# EUROPEAN PATENT APPLICATION

(11) **EP 4 026 641 A1**
(43) Date of publication of application: **13.07.2022**
(21) Application number: 20861439.6
(22) Date of filing: 31.08.2020
(51) Int. Cl.: B23K 1/00, B23K 1/08, H05K 3/34

(54) **DETECTION DEVICE, DETECTION METHOD, AND PROGRAM**

(30) Priority: 06.09.2019 JP 2019162776
(71) Applicant: OMRON Corporation, Shiokoji-dori, Shimogyo-Ku Kyoto-shi Kyoto 600-8530 (JP)
(72) Inventor: KUBOTA, Tetsuro, Kyoto-shi, Kyoto 600-8530 (JP)
(74) Representative: Becker, Eberhard
(86) International application number: PCT/JP2020/032842
(87) International publication number: WO 2021/044997

(57) **Abstract**

The detection device comprises: an acquisition unit for acquiring the temperature of a solder in a solder bath; a measurement unit for measuring the melting point of the solder from a temporal change in temperature in at least one of a temperature increasing process and a temperature decreasing process; and a detection unit for detecting variation in the copper concentration of the solder on the basis of variation in the melting point. This facilitates highly frequent detection of variation in the copper concentration of the copper.

## Description

### Technical Field

The disclosure relates to a detection device, a detection method, and a program.

### Related Art

In a soldering process using a lead-free solder, copper melts into the solder from the lead portion of an electronic component and the exposed electrode portion of a substrate, and the copper concentration of the solder in a solder bath increases. When the copper concentration of solder increase, the melting point of solder increase. An increase in the melting point of the solder causes deterioration of wettability and increases the occurrence frequency of soldering failure. Therefore, the copper concentration of the solder is controlled.

As a method of controlling the copper concentration of solder, there are methods using various analyzers. For example, solder drawn out from a solder bath is poured into a mold to produce an ingot-like sample, and the copper concentration of the solder is analyzed using titration or spectrophotometric methods (X-ray fluoresence analysis, ICP (inductively coupled plasma) emission spectroscopy, etc.).

Japanese Unexamined Patent Publication No. 2007-80891 (Patent Literature 1) discloses a method of estimating the copper concentration of solder without using an analyzer. The estimation method disclosed in Patent Literature 1 estimates changes over time in the copper concentration of solder in a solder bath using the relationship between the copper concentration of solder and the copper solubility of the lead portion of an electronic component and the exposed electrode portion of a substrate, and the relationship between the dross removal time interval and the amount of dross produced.

### Citation List

### Patent Literature

[Patent Literature 1] Japanese Unexamined Patent Publication No. 2007-80891

### SUMMARY OF INVENTION

### Technical Problem

When analyzing the copper concentration using an analyzer, it usually takes time and costs to obtain the analysis result by submitting samples to an external analysis manufacturer. Therefore, the copper concentration cannot be measured frequently, and the concentration is measured only once a month, for example. Since the occurrence frequency of soldering failure increases when the copper concentration of solder increases, it is preferable that the copper concentration be measured at a high frequency.

In the technique disclosed in Patent Literature 1, the relationship between the copper concentration of solder and the copper solubility of the lead portion of an electronic component and the exposed electrode portion of a substrate, and the relationship between the time interval for removing dross and the amount of dross produced must be obtained in advance. Further, since complicated calculation is performed, the calculation load is increased.

The disclosure has focused on the above problems and an object thereof is to provide a detection device, a detection method and a program facilitating highly frequent detection of variation in the copper concentration of the solder.

### Solution to Problem

According to an example of the disclosure, a detection device includes: an acquisition unit for acquiring a temperature of a solder in a solder bath; a measurement unit for measuring a melting point of the solder from a temporal change in the temperature in at least one of a temperature increasing process and a temperature decreasing process; and a detection unit for detecting variation in a copper concentration of the solder on the basis of variation in the melting point.

According to the disclosure, variation in the copper concentration of solder can be easily detected on the basis of temporal change in the temperature of the solder in at least one of the temperature increasing process and the temperature decreasing process. The variation in the copper concentration of the solder can be detected in the temperature increasing process or the temperature decreasing process. Therefore, the variation in the copper concentration of the solder can be detected at a high frequency. Thus, the variation in the copper concentration of the solder can be easily detected at a high frequency.

In the above disclosure, the detection unit detects an abnormality in the copper concentration when the melting point exceeds a first threshold value.

According to the disclosure, the abnormality of the copper concentration can be easily detected by comparing the melting point with the first threshold value. Thus, the operator can perform maintenance or the like at an appropriate timing.

In the above disclosure, the detection unit detects an abnormal sign of the copper concentration when the melting point exceeds a second threshold value smaller than the first threshold value.

According to the disclosure, the abnormal sign of copper concentration can be easily detected by comparing the melting point with the second threshold value. Thus, the operator can perform preparation such as maintenance in advance.

In the above disclosure, the acquisition unit acquires the temperature at each predetermined cycle after energization to a heater for heating the solder in the solder bath is started. According to the disclosure, the measurement unit may measure the melting point from the temporal change in temperature in the temperature increasing process.

In the above disclosure, the acquisition unit acquires the temperature at each predetermined cycle after energization to a heater for heating the solder in the solder bath is stopped. According to the disclosure, the measurement unit may measure the melting point from the temporal change in temperature in the temperature decreasing process.

According to an example of the disclosure, the detection method includes: a step of acquiring a temperature of a solder in a solder bath; a step of measuring a melting point of the solder from a temporal change in temperature in at least one of a temperature increasing process and a temperature decreasing process; and a step of detecting variation in a copper concentration of the solder on the basis of variation in the melting point. According to an example of the disclosure, a program causes a computer to execute the above detection method. With these disclosures, variation in the copper concentration of solder can be easily detected at a high frequency.

### Effects of Invention

According to the disclosure, variation in the copper concentration of the solder can be easily detected at a high frequency.

### BRIEF DESCRIPTION OF DRAWINGS

Figure 1 is a schematic view showing an overall configuration of a soldering system according to the present embodiment.
Figure 2 is a schematic diagram showing a hardware configuration of a detection device.
Figure 3 is a diagram showing an example of temporal change in temperature of a solder in a temperature increasing process and a temperature decreasing process.
Figure 4 is a diagram showing the relationship between the copper concentration and the melting point of the solder.
Figure 5 is a flowchart showing a flow of detection process of the variation in the copper concentration when energization to a heater is started.
Figure 6 is a flowchart showing a flow of detection processing of the variation in copper concentration when energization to a heater is stopped.

### DESCRIPTION OF EMBODIMENTS

### <Example of application>

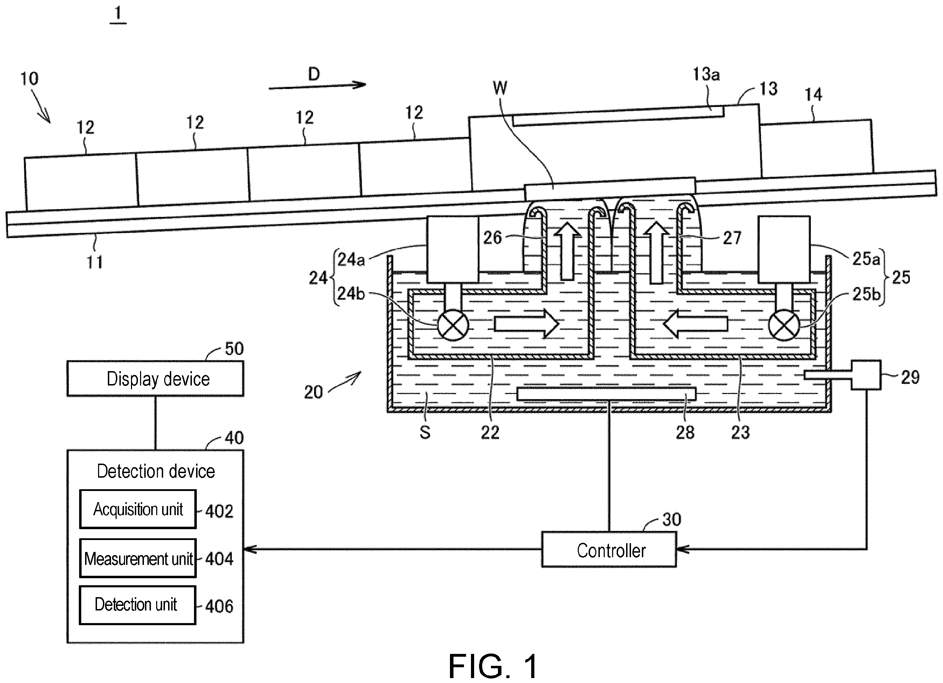

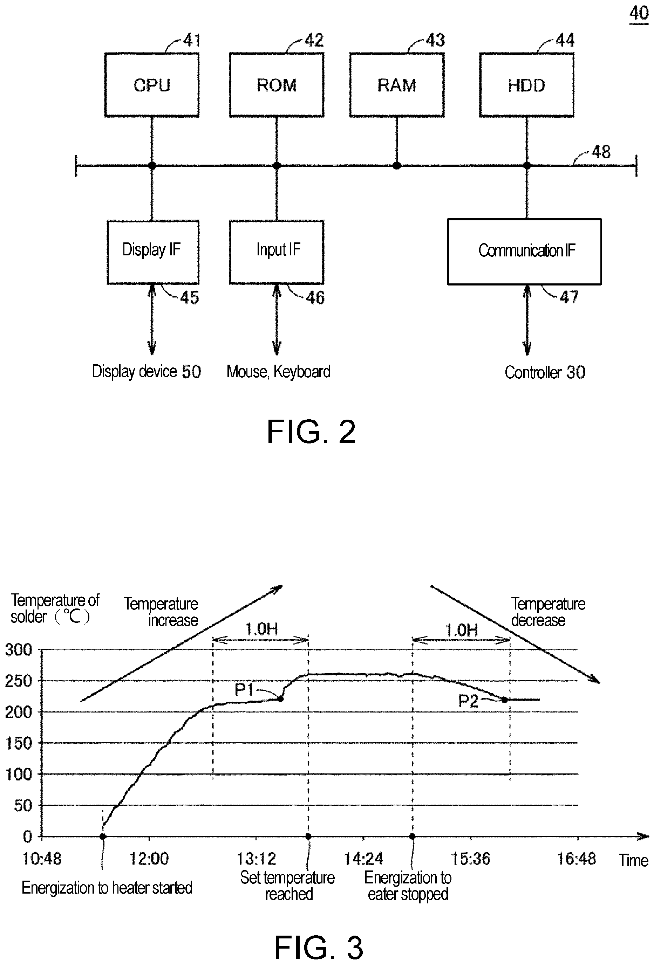

An example of a situation to which the present invention is applied will be described with reference to FIGS. 1 and 2. Figure 1 is a schematic view showing an overall configuration of a soldering system according to the present embodiment.

As shown in Figure 1, a soldering system 1 includes a transport device 10 for transporting a substrate W; a jet-type soldering device 20 for ejecting molten solder S onto the substrate W to perform soldering; a controller 30; a detection device 40; and a display device 50.

The jet-type soldering device 20 includes a solder bath 21, ducts 22, 23, pumps 24, 25, a primary jet nozzle 26, a secondary jet nozzle 27, a heater 28, and a thermometer 29.

The solder bath 21 accommodates the solder S. The heater 28 for heating the solder in the solder bath 21 is installed in the solder bath 21. By energizing the heater 28, the solder S in the solder bath 21 is heated and melted.

The thermometer 29 is attached to the solder bath 21. The thermometer 29 is composed of, for example, a thermocouple, and measures the temperature of the solder S accommodated in the solder bath 21 at predetermined cycles (for example, one second).

The ducts 22 and 23 are installed in the solder bath 21. The pumps 24 and 25 pump the molten solder S into the ducts 22 and 23, respectively. The pump 24 includes, for example, a motor 24a and an impeller 24b rotated by the motor 24a. The pump 25 includes, for example, a motor 25a and an impeller 25b rotated by the motor 25a.

The primary jet nozzle 26 is connected to the duct 22. The primary jet nozzle 26 changes the flow of the solder S pumped in the duct 22 upward in the vertical direction, and ejects the solder S from an opening at an upper end. The primary jet nozzle 26 produces a primary jet having a wavy surface.

The secondary jet nozzle 27 is connected to the duct 23. The secondary jet nozzle 27 changes the flow of the solder S pumped in the duct 23 upward in the vertical direction, and ejects the solder S from an opening at an upper end. The secondary jet nozzle 27 produces a secondary jet having a flat surface.

The transport device 10 transports the substrate W to be soldered toward above the primary jet nozzle 26 and the secondary jet nozzle 27. The transport device 10 includes a transport belt 11, a plurality of preheating devices (preheaters) 12, a frame 13, and a cooling device 14.

The transport belt 11 transports the substrate W along a transport direction D at a constant speed. The plurality of preheating devices 12 are arranged on an upstream side from above the primary jet nozzle 26 and the secondary jet nozzle 27 in the transport belt 11 to preheat the substrate W.

The frame 13 is installed above the primary jet nozzle 26 and the secondary jet nozzle 27. An observation window 13a is formed in the frame 13, and the primary jet from the primary jet nozzle 26 and the secondary jet from the secondary jet nozzle 27 may be observed from above through the observation window 13a.

The cooling device 14 is arranged on a downstream side from above the primary jet nozzle 26 and the secondary jet nozzle 27 in the transport belt 11 on the downstream side to cool the substrate W.

The controller 30 is a temperature control device that controls the jet-type soldering device 20. When a start instruction of the jet-type soldering device 20 is input, the controller 30 starts energization to the heater 28 such that the temperature measured by the thermometer 29 becomes the set temperature. The controller 30 rotates the motors 24a and 25a at the timing when the temperature measured by the thermometer 29 reaches the set temperature or the timing when the jet start instruction is input, and ejects the solder S from the primary jet nozzle 26 and the secondary jet nozzle 27. When a stop instruction of the jet-type soldering device 20 is input, the controller 30 stops the rotation of the motors 24a and 25a and stops energization to the heater 28.

The controller 30 outputs the temperature measured at each predetermined cycle by the thermometer 29 to the detection device 40.

The detection device 40 detects variation in the copper concentration of the solder S in the solder bath 21. The detection device 40 includes an acquisition unit 402, a measurement unit 404, and a detection unit 406.

The acquisition unit 402 acquires the temperature of the solder in the solder bath 21 measured at each predetermined cycle by the thermometer 29 from the controller 30. The acquisition unit 402 may directly acquire the temperature measured at each predetermined cycle from the thermometer 29.

The measurement unit 404 measures the melting point (liquidus temperature) of the solder S from the temporal change in temperature acquired by the acquisition unit 402. Specifically, the measurement unit 404 measures the melting point of the solder from the temporal change in temperature in the temperature increasing process after energization to the heater 28 is started. Alternatively, the measurement unit 404 measures the melting point of the solder S from the temporal change in temperature in the temperature decreasing process after energization to the heater 28 is stopped.

The detection unit 406 detects variation in the copper concentration of the solder S on the basis of variation in the melting point measured by the measurement unit 404. The detection unit 406 displays the detection result on the display device 50. As a result, the operator confirms variation in the copper concentration of the solder and performs maintenance of the solder bath 21 as necessary. For example, the operator discards part or all of the solder in the solder bath 21 and supplies new solder having an appropriate copper concentration. Alternatively, the operator may discard part of the solder in the solder bath 21 and supply the solder having a low copper concentration.

According to the present embodiment, the variation in the copper concentration of the solder S can be easily detected on the basis of the temporal change in temperature of the solder S in at least one of the temperature increasing process and the temperature decreasing process. The variation in the copper concentration of the solder S may be detected at the timing of starting or stopping of energization to the heater 28. Therefore, for example, when the jet-type soldering device 20 is started on Monday and the jet-type soldering device 20 is stopped on Friday, the variation in the copper concentration of the solder S may be detected twice a week. In this way, the variation in the copper concentration of the solder S can be easily detected at a high frequency.

<Specific example>

### (Hardware configuration of detection device)

Figure 2 is a schematic diagram showing the hardware configuration of the detection device. The detection device 40 is realized by, for example, a general-purpose computer. As shown in Figure 2, the detection device 40 includes a CPU (central processing unit) 41, a ROM (read only memory) 42, a RAM (random access memory) 43, a hard disk (HDD) 44, a display interface (IF) 45, an input IF 46, and a communication IF 47. Each of these parts is connected to each other via a bus 48 so as to be capable of data communication.

The CPU 41 executes various programs including the OS. The ROM 42 stores BIOS and various data. The RAM 43 provides a work area for storing data necessary for executing a program in the CPU 41. The HDD 44 non-volatilely stores a program or the like executed by the CPU 41. The measurement unit 404 and the detection unit 406 shown in Figure 1 are realized by the CPU 41 executing a program.

The display IF 45 is an interface that outputs data to the display device 50 according to the instructions of the CPU 41. The input IF 46 is an interface for receiving data from an input device such as a mouse and a keyboard. The communication IF 47 is an interface for transmitting and receiving data to and from the controller 30 via a network according to the instructions of the CPU 41. The communication IF 47 receives, for example, the temperature measured from the controller 30. The acquisition unit 402 shown in Figure 1 is realized by the communication IF 47.

### (Method of measuring melting point)

Next, a method of measuring the melting point by the measurement unit 404 will be described with reference to Figure 3. Figure 3 is a diagram showing an example of temporal change in temperature of the solder S in the temperature increasing process and the temperature decreasing process. In Figure 3, a temperature waveform when energization to the heater 28 is started when the solder S is at room temperature and when energization to the heater 28 is stopped after holding the heater 28 at a set temperature of 260 °C for about one hour is shown.

As shown in Figure 3, in the temperature increasing process from the start of energization to the heater 28 to the temperature of the solder S reaching the set temperature of 260 °C, there is a period in which the temperature of the solder S is kept constant (about 220 °C in the example shown in Figure 3). This is because heat generated from the heater 28 is consumed for melting the solder S. After a timing P1 when all the solder S is melted, the temperature of the solder S increases again. The secondary differential value of the temperature waveform at the timing P1 shows the maximum.

The timing P1 appears in a past period within a predetermined time (one hour in the example shown in Figure 3) from the timing when the temperature of the solder S reaches the set temperature of 260 °C. The predetermined time is determined according to the capacity of the heater 28, the capacity of the solder bath 21, and the like. The measurement unit 404 extracts, as the timing P1, a time point at which the secondary differential value of the temperature waveform becomes maximum from the past period for a predetermined time from the timing when the temperature of the solder S reaches the set temperature 260 °C for the first time. The measurement unit 404 may determine the temperature at the extracted timing P1 as the melting point of the solder S.

As shown in Figure 3, in the temperature decreasing process after energization to the heater 28 is stopped, there is a period in which the temperature of the solder S is kept constant (about 220 °C. in the example shown in Figure 3). This is because the heat (heat of solidification) due to the solidification of the solder S is released. That is, the temperature of the solder S deceases when energization to the heater 28 is stopped, but the temperature of the solder S is kept constant after a timing P2 when the solder S starts to solidify. The secondary differential value of the temperature waveform at the timing P2 shows the maximum.

The timing P2 appears in a period from the timing when energization to the heater 28 is stopped to the time when a predetermined time (1 hour in the example shown in Figure 3) elapses. The predetermined time is determined according to the capacity of the solder bath 21 and the like. The measurement unit 404 extracts, as the timing P2, a time point at which the secondary differential value of the temperature waveform becomes maximum from a period from the timing when energization to the heater 28 is stopped to the elapse of a predetermined time. The measurement unit 404 may determine the temperature at the extracted timing P2 as the melting point of the solder S.

The measurement unit 404 may perform a smoothing process on the temperature waveform in order to exclude the effect of a minute temperature change. The measurement unit 404 may extract, as the timing P1 or the timing P2, the timing at which the secondary differential value becomes maximum from the temperature waveform subjected to the smoothing process. As a result, it is possible to suppress a decrease in the measurement accuracy of the melting point due to the effect of a minute temperature change.

### (Method of detecting variation in copper concentration)

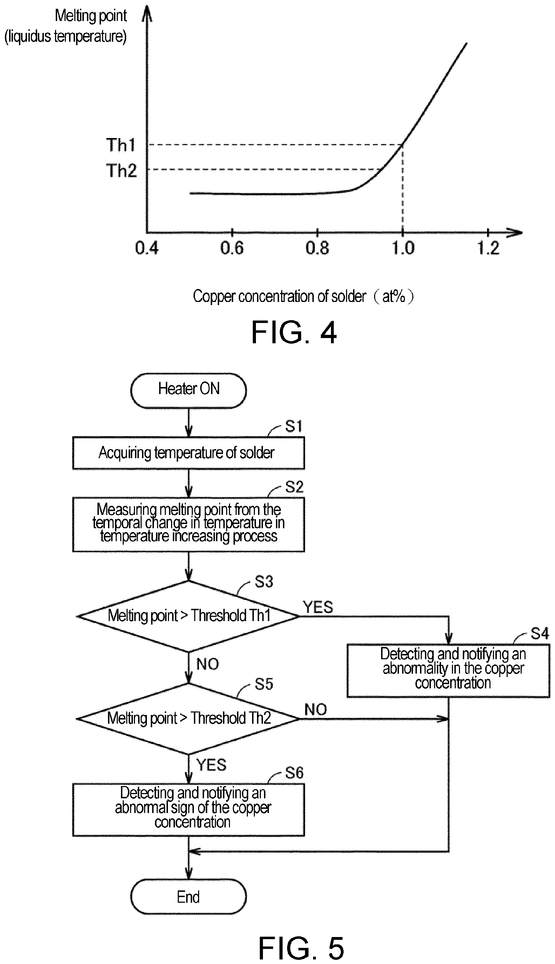

Next, with reference to Figure 4, a method of detecting variation in the copper concentration by the detection unit 406 will be described. Figure 4 is a diagram showing the relationship between the copper concentration and the melting point of the solder. As shown in Figure 4, as the copper concentration of the solder S increases, so does the melting point of the solder S. Therefore, the detection unit 406 may detect variation in the copper concentration of the solder S by comparing the melting point measured by the measurement unit 404 with a predetermined threshold value.

For example, when the copper concentration of the solder S is to be controlled to 1.0 at% (atomic percent) or less, the melting point of the solder S when the copper concentration is 1.0 at% is predetermined as a threshold value Th1. When the melting point measured by the measurement unit 404 exceeds the threshold value Th1, the detection unit 406 may detect an abnormality in the copper concentration of the solder S. That is, the detection unit 406 detects the occurrence of an abnormal state in which the copper concentration exceeds the control standard (= 1.0 at%).

When an abnormality in the copper concentration is detected, the detection unit 406 causes the display device 50 to display a notification screen for notifying the abnormality in the copper concentration of the solder S. Thus, the operator can immediately grasp the abnormality of the copper concentration by confirming the notification screen. As a result, the operator can perform maintenance such as replacement of the solder S.

Further, as shown in Figure 4, a threshold value Th2 lower than the threshold value Th1 may be predetermined. When the melting point measured by the measurement unit 404 exceeds the threshold value Th2, the detection unit 406 may detect an abnormal sign of the copper concentration of the solder S. That is, the detection unit 406 detects a sign that the copper concentration exceeds the control standard (= 1.0 at%) in the near future.

When the detection unit 406, when detecting an abnormal sign of the copper concentration, casues the display device 50 to display a notification screen for notifying the abnormal sign of the copper concentration of the solder S. Thus, the operator can recognize that maintenance such as replacement of the solder S is necessary in the near future by confirming the notification screen, and can prepare for the maintenance in advance.

### (Flow of detection process)

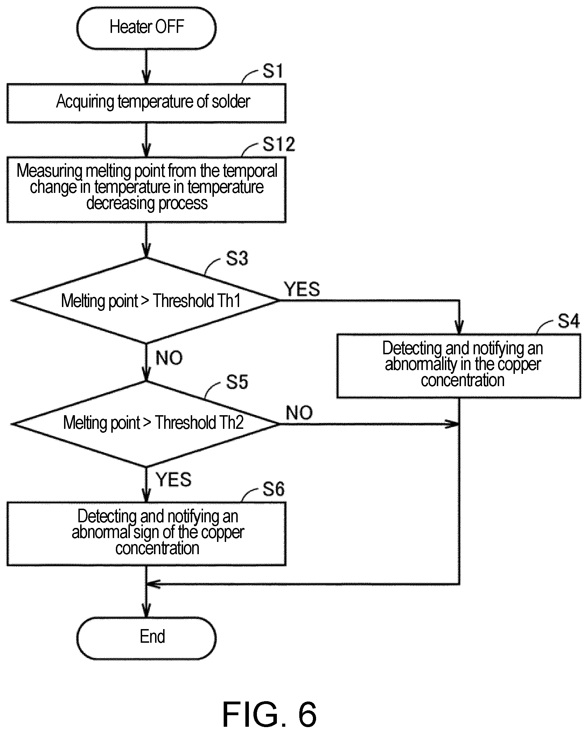

Next, the flow of the detection process in the detection device 40 will be described with reference to Figures 5 and 6. Figure 5 is a flowchart showing the flow of the detection process of variation in the copper concentration when energization to the heater is started.

When energization to the heater 28 is started, the detection device 40 acquires the temperature of the solder S in the solder bath 21 measured at each predetermined cycle by the thermometer 29 (step S1). The detection device 40 acquires the temperature of the solder S at each predetermined cycle in a temperature increasing process until the temperature of the solder S reaches a set temperature.

Next, the detection device 40 measures the melting point from the temporal change in temperature of the solder S in a temperature increasing process (step S2). For example, the detection device 40 determines, as the melting point, the temperature at the time when the secondary differential value of the temperature waveform becomes maximum from a past period for a predetermined time from the timing when the temperature of the solder S reaches the set temperature.

Next, the detection device 40 determines whether or not the measured melting point exceeds the threshold value Th1 (step S3). When the melting point exceeds the threshold value Th1 (YES in step S3), the detection device 40 detects an abnormality in the copper concentration of the solder S and displays a notification screen notifying the abnormality of the copper concentration on the display device 50 (step S4). After step S4, the detection process is ended.

When the melting point does not exceed the threshold value Th1 (NO in step S3), the detection device 40 determines whether or not the measured melting point exceeds the threshold value Th2 (<Th1) (step S5). When the melting point exceeds the threshold value Th2 (YES in step S5), the detection device 40 detects an abnormal sign of the copper concentration of the solder S, and displays a notification screen notifying the abnormal sign of the copper concentration on the display device 50 (step S6). After step S6, the detection process is ended.

Figure 6 is a flowchart showing the flow of the detection process of variation in the copper concentration when energization to the heater is stopped. The flowchart shown in Figure 6 is different from the flowchart shown in Figure 5 in that it includes a step S12 instead of the step S2.

In step S12, the detection device 40 measures the melting point from the temporal change in temperature of the solder S in the temperature decreasing process. For example, the detection device 40 determines, as the melting point, the temperature at the time when the secondary differential value of the temperature waveform becomes maximum from the period from the timing when energization to the heater 28 is stopped to the elapse of a predetermined time. Then, the variation in the copper concentration of the solder S is detected by performing steps S3 to S6 based on the melting point measured in step S12.

### (advantage)

As described above, the detection device 40 according to the present embodiment includes the acquisition unit 402, the measurement unit 404, and the detection unit 406. The acquisition unit 402 acquires the temperature of the solder S in the solder bath 21. The measurement unit 404 measures the melting point of the solder S from the temporal change in temperature in at least one of the temperature increasing process and the temperature decreasing process. The detection unit 406 detects variation in the copper concentration of the solder S on the basis of variation in the melting point.

According to the above configuration, the variation in the copper concentration of the solder S can be easily detected on the basis of the temporal change in the temperature of the solder S in at least one of the temperature increasing process and the temperature decreasing process. The variation in the copper concentration of the solder S may be detected at the timing of starting or stopping energization to the heater 28. Therefore, the variation in the copper concentration of the solder S can be detected at a high frequency. In this way, variation in the copper concentration of the solder S can be easily detected at a high frequency.

The detection unit 406 detects an abnormality in the copper concentration when the melting point exceeds the threshold value Th1. Further, when the melting point exceeds the threshold value Th2 smaller than the threshold value Th1, the detection unit 406 detects an abnormal sign of the copper concentration. In this way, an abnormality or an abnormality sign in the copper concentration can be easily detected by comparing the melting point with the threshold value Th1 and the threshold value Th2. As a result, the operator can perform maintenance or the like at an appropriate timing.

The acquisition unit 402 acquires the temperature at each predetermined cycle after energization to the heater 28 for heating the solder S in the solder bath 21 is started. Thus, the measurement unit 404 may measure the melting point from the temporal change in temperature in the temperature increasing process. Alternatively, the acquisition unit 402 may acquire the temperature at each predetermined cycle after energization to the heater 28 is stopped. Thus, the measurement unit 404 may measure the melting point from the temporal change in temperature in the temperature decreasing process.

### (Modification example)

In the above description, the detection device 40 determines the temperature of the timing P1 or the timing P2 (see Figure 2) as the melting point. However, the detection device 40 may determine, as the melting point, the average value of the temperatures in a past period from the timing P1 for a predetermined time (for example, one minute). Similarly, the detection device 40 may determine, as the melting point, the average value of the temperature in a period from the timing P2 to the elapse of a predetermined time (for example, one minute). Thus, the effect of measurement variation by the thermometer 29 can be suppressed.

In the above description, the melting point is measured from the temporal change in temperature in each of the temperature increasing process and the temperature decreasing process, and variation in the copper concentration of the solder S is detected. However, the melting point may be measured from the temporal change in temperature only in either the temperature increasing process or the temperature decreasing process, and variation in the copper concentration of the solder S may be detected.

Alternatively, variation in the copper concentration of the solder S may be detected using the average value of the melting point measured from the temporal change in temperature in the temperature increasing process and the melting point measured from the temporal change in temperature in the latest temperature decreasing process. That is, the average value may be compared with the threshold value Th1 and the threshold value Th2, and the variation in the copper concentration may be detected according to the comparison result.

In the above description, the detection device 40 and the controller 30 are separate bodies. However, the detection device 40 and the controller 30 may be integrated.

### <Additional Notes>

As described below, the present embodiment includes the following disclosures.

### (Structure 1)

A detection device (40), including:
an acquisition unit (402, 47) for acquiring a temperature of a solder (S) in a solder bath (40);
a measurement unit (404, 41) for measuring a melting point of the solder (S) from a temporal change in the temperature in at least one of a temperature increasing process and a temperature decreasing process; and
a detection unit (406, 41) for detecting variation in a copper concentration of the solder (S) on the basis of variation in the melting point.

### (Structure 2)

The detection device (40) according to the configuration 1, wherein the detection unit (406, 41) detects an abnormality in the copper concentration when the melting point exceeds a first threshold value.

### (Structure 3)

The detection device (40) according to configuration 2, wherein the detection unit (406, 41) detects an abnormal sign of the copper concentration when the melting point exceeds a second threshold value smaller than the first threshold value.

### (Structure 4)

The detection device (40) according to any one of configurations 1 to 3, wherein the acquisition unit (402, 47) acquires the temperature at each predetermined cycle after energization to a heater (28) for heating the solder (S) in the solder bath (21) is started.

### (Structure 5)

The detection device according to any one of configurations 1 to 3, wherein the acquisition unit (402, 47) acquires the temperature at each predetermined cycle after energization to a heater (28) for heating the solder (S) in the solder bath (21) is stopped.

### (Structure 6)

A detection method, including:
a step of acquiring a temperature of a solder (S) in a solder bath (21);
a step of measuring a melting point of the solder (S) from a temporal change in the temperature in at least one of a temperature increasing process and a temperature decreasing process; and
a step of detecting variation in a copper concentration of the solder on the basis of variation in the melting point.

### (Structure 7)

A program for causing a computer to execute a detection method according to the configuration 6.

Although embodiments of the present invention have been described, the embodiments disclosed herein should be considered to be exemplary and not restrictive in all respects. The scope of the present invention is indicated by the scope of claims and is intended to include all modifications within the meaning and scope equivalent to the scope of claims.

### Reference Signs List

- 1: Soldering system
- 10: Transport device
- 11: Transport belt
- 12: Preheating device
- 13: Frame
- 13a: Observation window
- 14: Cooling device
- 20: Jet-type soldering device
- 21: Solder bath
- 22, 23: Duct
- 24, 25: Pump
- 24a, 25a: Motor
- 24b, 25b: Impeller
- 26: Primary jet nozzle
- 27: Secondary jet nozzle
- 28: Heater
- 29: Thermometer
- 30: Controller
- 40: Detection device
- 41: CPU
- 42: ROM
- 43: RAM
- 44: HDD
- 45: Display IF
- 46: Input IF
- 47: Communication IF
- 48: Bus
- 50: Display device
- 402: Acquisition unit
- 404: Measurement unit
- 406: Detection unit
- S: Solder
- W: Substrate

## Claims

1. A detection device, comprising:
an acquisition unit for acquiring a temperature of a solder in a solder bath;
a measurement unit for measuring a melting point of the solder from a temporal change in the temperature in at least one of a temperature increasing process and a temperature decreasing process; and
a detection unit for detecting variation in a copper concentration of the solder on the basis of variation in the melting point.

2. The detection device according to claim 1, wherein the detection unit detects an abnormality in the copper concentration when the melting point exceeds a first threshold value.

3. The detection device according to claim 2, wherein the detection unit detects an abnormal sign of the copper concentration when the melting point exceeds a second threshold value smaller than the first threshold value.

4. The detection device according to any one of claims 1 to 3, wherein the acquisition unit acquires the temperature at each predetermined cycle after an energization to a heater for heating the solder in the solder bath is started.

5. The detection device according to any one of claims 1 to 3, wherein the acquisition unit acquires the temperature at each predetermined cycle after an energization to a heater for heating the solder in the solder bath is stopped.

6. A detection method, comprising:
a step of acquiring a temperature of a solder in a solder bath;
a step of measuring a melting point of the solder from a temporal change in the temperature in at least one of a temperature increasing process and a temperature decreasing process; and
a step of detecting variation in a copper concentration of the solder on the basis of variation in the melting point.

7. A program for causing a computer to execute a detection method according to claim 6.
